# EUROPEAN PATENT APPLICATION

(11) **EP 2 549 548 A1**
(43) Date of publication of application: **23.01.2013**
(21) Application number: 11756474.0
(22) Date of filing: 22.03.2011
(51) Int. Cl.: H01L 31/04

(54) **SOLAR CELL HAVING POROUS STRUCTURE IN WHICH METAL NANOPARTICLES ARE CARRIED IN PORES**

(30) Priority: 19.03.2010 JP 2010063647
(71) Applicant: Tokyo Institute of Technology, Tokyo 152-8550 (JP)
(72) Inventor: IHARA Manabu, Tokyo 152-8550 (JP); TANAKA Yuki, Tokyo 152-8550 (JP); HACHIMURA Hironori, Tokyo 152-8550 (JP)
(74) Representative: von Kreisler Selting Werner
(86) International application number: PCT/JP2011/056804
(87) International publication number: WO 2011/115292

(57) **Abstract**

The present invention intends to provide a solar cell that has, by an increase in the absorbance of light of a surface of a solar cell, a reduction in the reflectance, and so on, a high energy conversion efficiency. The problem was solved by a pn junction type semiconductor solar cell that has a porous structure on a surface thereof, characterized in that metal nanoparticles having a surface plasmon absorption are supported in pores present in the porous structure, further, by a pn junction type semiconductor solar cell in which the porous structure is formed in a photoelectric material itself in a pn junction type semiconductor solar cell, or, the porous structure is formed in a light transmission layer disposed on a surface of a pn junction type semiconductor solar cell.

## Description

### Technical Field

The present invention relates to a solar cell having a porous structure in which metal nanoparticles are supported in pores, in more detail, a solar cell such as a pn junction semiconductor solar cell and so on, of which conversion efficiency is improved by surface plasmons that metal nanoparticles have.

### Background Art

A solar cell is gathering an attention as an energy system that can solve energy resources depletion and environmental contamination. However, it is said that in order to achieve broad use of the solar cell, a higher efficiency and a lower cost are necessary. In order to achieve a higher efficiency, it is necessary that the absorbance of light of a surface of a photoelectric conversion layer of a solar cell is enhanced or the reflectance thereof is reduced to efficiently convert solar energy illuminated on a surface of a photoelectric conversion layer into electric energy.

So, in order for a solar cell to efficiently absorb solar light, there is a technology in which a light receiving surface of a solar cell is coated with an anti-reflection film. As an anti-reflection film of this kind, a technology where a material for anti-reflection film is imparted on a surface by PVD, vapor deposition, spraying, dipping or other methods, followed by heating has been known. Further, also a technology where according to a plasma CVD method, a film of silicon nitride containing hydrogen is formed on a light receiving surface of a solar cell is known (patent document 1). Still further, a passivation effect where hydrogen in a silicon nitride film that is an anti-reflection film of a solar cell is diffused in a silicon substrate of a solar cell to improve the efficiency of a solar cell is known (patent document 2).

Further, also a technology where a light-absorbing layer (light-absorbing thin film) is used to efficiently absorb solar light is known (patent documents 3 to 5, for example).

By contrast, in metal nanoparticles, there are plasmons localized on a surface of the metal nanoparticles, and the localized (surface) plasmons thereof couple with an electric field of light from near infrared to near ultraviolet to cause light absorption. This phenomenon is known as localized (surface) plasmons resonance (Surface Plasmon Resonance: SPR). As a result thereof, a locally enhanced electric field is generated and light energy is converted into surface plasmons, thereby energy of light is stored on a surface of metal nanoparticles. Further, there are resonance wavelengths depending on a particle size or the dielectric constant of an environmental medium.

As a technology that uses this phenomenon for improving the absorbance of light of a solar cell or an energy conversion efficiency thereof, non-patent document 1 and patent document 6 of the inventors of the present application are known. The non-patent document 1 describes that when silver nanoparticles are used, the absorbance index of a dye N3Dye used in a dye-sensitized solar cell was increased up to 149 times at the maximum. Further, in patent document 6, it is described that by use of the enhanced effect, a dye-sensitized solar cell that supports silver nanoparticles in a titania porous film was prepared, and thereby an improvement in the conversion efficiency was achieved.

Further, in patent document 7, a solar cell is described, in which on a metal film on which a light responsive molecule is fixed, a light-illuminating portion having the dielectric constant different from that of the metal film is deposited, and the surface plasmons resonance in an interface between the metal film and the light-illuminating portion is utilized. Still further, in patent document 8, a technology is described in which in a dye-sensitized solar cell, in a laminate structure of metal fine particles and semiconductor fine particles, according to an interaction between regularly-arranged metal fine particles each other, the surface plasmons resonance is enhanced to improve the absorbance of light of a photosensitizer adsorbed on metal fine particles.

In recent years, a demand for an improvement in the energy conversion efficiency of a solar cell is very strong. According to the above-described known technologies, an improvement in the absorbance of light and reduction of the reflectance are still insufficient, and a further improvement thereof is in demand.

### Prior art document

### Patent document

Patent document 1: JP 2000-299482 A
Patent document 2: JP 2003-273382 A
Patent document 3: JP 2006-228867 A
Patent document 4: JP 2009-054936 A
Patent document 5: JP 2009-135517 A
Patent document 6: JP 2007-265694 A
Patent document 7: JP 10-340742 A
Patent document 8: JP 2007-335222 A

### Non-patent document

Non-patent document 1 : M. Ihara et al, J. Phys. Chem. B 101, 5153, (1997)

### Disclosure of the Invention

### Problem that the Invention Is to Solve

The present invention was conducted in view of the above-described background art, and an object thereof is to provide a solar cell in which by an increase in the absorbance of light of a surface of a solar cell, a reduction in the reflectance thereof, and so on, a high energy conversion efficiency is achieved.

### Means for Solving the Problem

The present inventors found, after studying hard to solve the problem, that when a porous structure is formed on a surface of a solar cell, and, in pores present in the porous structure, metal nanoparticles having a surface plasmon absorption are supported, a distance between the "metal nanoparticles having a surface plasmon absorption" and an inner wall of "pores present in the porous structure" is shortened, and a contact area therebetween is increased, thereby electric field enhancement owing to the surface plasmons can be more effectively utilized.

Further, it was found that when an anodic oxidation is conducted with a specified electrolyte solution, a porous structure can be formed on a silicon surface, and when metal nanoparticles having a specified surface modification compound on a surface thereof are used, the metal nanoparticles can be allowed to very excellently intrude in pores present in the porous structure and can be supported by the inner wall of the pores.

As a result, it was found that the reflectance is largely reduced by the surface plasmon resonance, and a high energy conversion efficiency can be achieved.

That is, the present invention provides a pn junction type semiconductor solar cell having a porous structure on a surface thereof, in which in pores present in the porous structure, metal nanoparticles having a surface plasmon absorption are supported.

Further, the present invention provides a solar cell having a porous structure on a surface thereof, characterized in that a material in which the porous structure is formed is silicon, and, in pores present in the porous structure, metal nanoparticles having a surface plasmon absorption are supported.

### Effect of the Invention

According to the present invention, the problematic points and problems can be solved, and a solar cell having a high energy conversion efficiency, in which owing to an electric field enhancement effect due to surface plasmons of metal nanoparticles, an increase in the absorbance of light, reduction in the reflectance and the like are achieved, can be provided. Further, a solar cell that has an antireflection effect that makes use of scattering due to surface plasmons can be provided. Still further, since the reflectance can be reduced by only having a porous structure on a surface, further, thereon, the reduction of the reflectance due to surface plasmons of the metal nanoparticles can be added.

Further, when, in a pn junction type semiconductor solar cell, the porous structure is formed in a photoelectric material itself such as silicon and so on, electric field enhancement owing to surface plasmons can be more effectively transmitted to a photoelectric material such as silicon and so on and can be used. While in patent document 6, in a dye-sensitized solar cell, the sensitizing dye is sensitized by surface plasmon absorption of metal nanoparticles, in the case of the present invention, an electric field enhancement effect owing to surface plasmons directly affects on a photoelectric material itself.

Further, when a porous structure is not substantially formed in a photoelectric material itself but is formed in a light transmission layer that is separately disposed on a surface of a solar cell, without restricting the kind of a solar cell to be applied, the technology can be applied to many kinds of solar cells such as semiconductor solar cells such as a silicon solar cell, a compound semiconductor solar cell and so on; organic solar cells such as a dye-sensitized solar cell and so on; and so on.

When metal nanoparticles having a surface plasmon absorption are supported in pores present in a porous structure, an amount of metal nanoparticles that are supported and affect on a sensitization effect can be increased, a distance between "metal nanoparticles having a surface plasmon absorption" and "pores present in the porous structure" can be shortened, and a contact area can be increased. As a result, a solar cell in which a surface plasmon absorption and/or scattering can be more effectively used, the absorbance of light is increased and/or the reflectance is decreased, and the conversion efficiency is improved can be provided.

### Brief Description of the Drawings

Figure 1 is a schematic sectional diagram of a pn junction type semiconductor solar cell according to an aspect 1(1) of the present invention in a state where metal nanoparticles are supported in pores present in a porous structure;
Figure 2 is a schematic sectional diagram illustrating an example of a preferable state of a pn junction type semiconductor solar cell according to the aspect 1(1) of the present invention;
Figure 3 is a schematic diagram of an example of a device when a porous structure is formed on a silicon surface by anodic oxidation;
Figure 4 illustrates a scanning electron microscope (SEM) photograph of a section of a porous structure (pore) in the present invention;
Figure 5 is a diagram illustrating an observation result by atomic force microscope (AFM) of a porous structure (pore) in the present invention. Figure 5(a): AFM image, and Figure 5(b): concavoconvex structure of a horizontal line portion of Figure 5(a);
Figure 6 includes SEM images and energy dispersive X-ray analysis (EDS) images of sections before and after introduction of metal nanoparticles (gold nanoparticles) into a porous structure (pore) (in measured images, intensity is differentiated by color);
Figure 7 illustrates reflection spectrum measurements of a pn junction type semiconductor solar cell of the present invention. Upper line: silicon substrate, middle line: silicon substrate on a surface of which a porous structure is formed by anodic oxidation (before introduction of AuNP), and lower line: silicon substrate that supports gold nanoparticles in pores of a porous structure (after introduction of AuNP);
Figure 8 is a schematic diagram illustrating only a light transmission layer in the present invention of an aspect 1 (2) ;

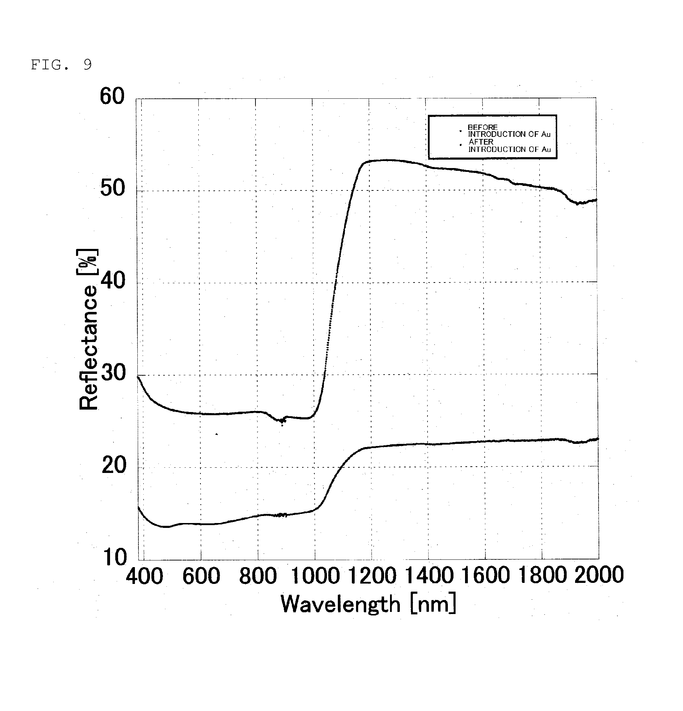

Figure 9 illustrates measurements of reflection spectra of a pn junction type semiconductor solar cell (A porous structure is formed after a pn-junction is formed. In other drawings, unless shown otherwise particularly with a bracket, a spectrum of a porous structured film before a pn-junction is formed is shown.) of the present invention. Upper line: a silicon substrate on a surface of which a porous structure is formed by anodic oxidation on (before introduction of gold nanoparticles), and lower line: a silicon substrate in which gold nanoparticles are supported in pores of a porous structure (after introduction of gold nanoparticles);
Figure 10 illustrates scanning electron microscope (SEM) photographs of a porous structure (pores) before and after dry etching in the present invention. An upper line: after dry etching, and a lower line: before dry etching;

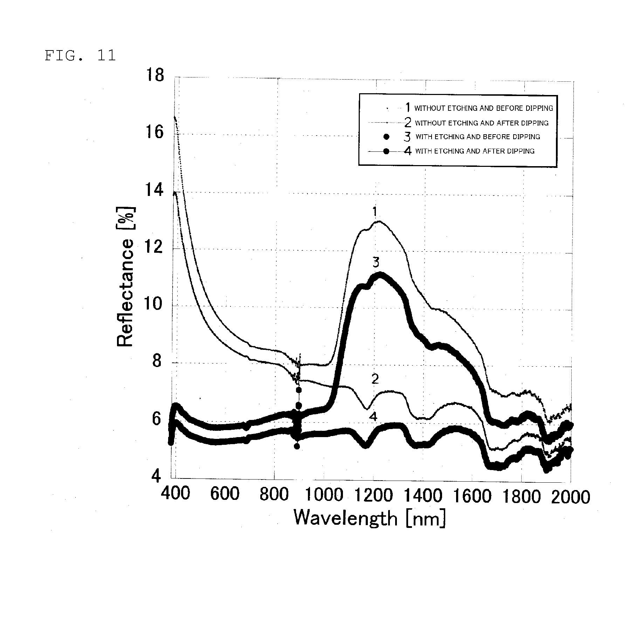

Figure 11 illustrates measurements of reflection spectra of a pn junction type semiconductor solar cell of the present invention. Line 1: silicon substrate on a surface of which a porous structure is formed by anodic oxidation (without etching and before dipping), line 2: silicon substrate that supports gold nanoparticles in pores of the porous structure of 1 (without etching and after dipping), line 3: silicon substrate on a surface of which a porous structure is formed by anodic oxidation and dry etching (etching and before dipping), and line 4: silicon substrate where gold nanoparticles are supported in pores of the porous structure of the 3 (etching and after dipping);
Figure 12 illustrates a SEM image and an energy dispersive X-ray analysis (EDS) image of a cross-section after metal nanoparticles (silver nanoparticles) are introduced in a porous structure (pore). Left: SEM image, and right: EDS image (in a measured image, a portion where an intensity of a Ag L line (2.983 keV) is strong is colored in green);
Figure 13 illustrates measurements of reflection spectra of a pn junction type semiconductor solar cell of the present invention. Line 1: Si substrate, line 2: Si substrate on which a porous structure is formed, followed by etching (2: etching for 30 min), and line 3: silicon substrate where silver nanoparticles are supported in pores of the porous structure of the 2 (3. etching for 30 min and with AgNP supported);
Figure 14 illustrates measurements of reflection spectra of a pn junction type semiconductor solar cell (a porous structure is formed after a pn-junction is formed) of the present invention (Example 5). Upper line: silicon substrate on a surface of which a porous structure is formed (before introduction of gold nanoparticles), and lower line: silicon substrate that supports gold nanoparticles in pores of a porous structure (after introduction of gold nanoparticles);
Figure 15 illustrates measurements of reflection spectra of a pn junction type semiconductor solar cell (a porous structure is formed after a pn-junction is formed) of the present invention (Example 6). Upper line: silicon substrate on a surface of which a porous structure is formed (before introduction of gold nanoparticles), and lower line: silicon substrate that supports gold nanoparticles in pores of a porous structure (after introduction of gold nanoparticles); and
Figure 16 is a scanning electron microscope (SEM) photograph of a porous structure (pores) when TiO₂ (titania) is used as a material where a porous structure is present.

### Explanation of reference numerals

11: PN JUNCTION TYPE SEMICONDUCTOR SOLAR CELL,
12: LAYER OF PHOTOELECTRIC MATERIAL A,
13: LAYER OF PHOTOELECTRIC MATERIAL B,
14: LIGHT TRANSMISSION LAYER,
15: POROUS STRUCTURE,
16: PORE
17: METAL NANOPARTICLES

### Best Mode for Carrying Out the Invention

In what follows, the present invention will be described. However, the present invention is not restricted to the following specific modes but can be optionally modified within a range of the technical ideas.

An aspect 1 of the present invention relates to a pn junction type semiconductor solar cell. The aspect 1 includes two kinds of an aspect 1 (1) and an aspect 1 (2). According to the aspect 1(1), a porous structure is formed in a photoelectric material itself in a pn junction semiconductor type solar cell, and, according to the aspect 1(2), a porous structure is formed in a light transmission layer disposed on a surface of a pn junction type semiconductor solar cell.

### <Aspect 1 (1)>

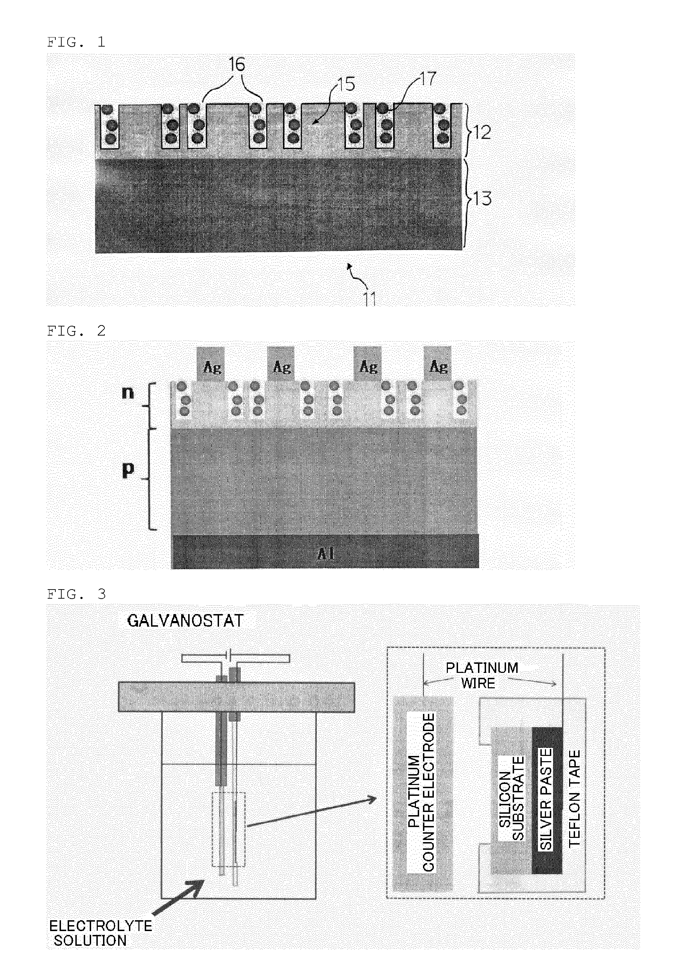

In Figure 1, a schematic sectional view of a pn junction type semiconductor solar cell of the aspect 1 (1) of the present invention is shown. Apn junction type semiconductor solar cell 11 of the aspect 1 (1) of the present invention has a porous structure 15 on a surface thereof, and, in pores 16 present in the porous structure 15, metal nanoparticles 17 having a surface plasmon absorption are supported. In an aspect 1 (1) that is particularly preferable aspect, as illustrated in Figure 1, a porous structure 15 is formed in a photoelectric material itself in a pn junction semiconductor type solar cell. When a porous structure 15 is formed in a photoelectric material itself, an electric field enhancement effect due to the surface plasmon preferably directly reaches a photoelectric material itself such as silicon and the like. Particularly preferably, in a pn junction type semiconductor solar cell, a porous structure 15 is formed in a material itself having a photoelectric effect on a longer wavelength side than a plasmon absorption of silver nanoparticles in visible light.

Here, a photoelectric material may be a material formed of a single component or a material formed of multi-components. As long as a material has the photoelectric effect with light of a wavelength longer than a wavelength of light having a plasmon absorption, principally, all materials can be used.

A layer 12 of a photoelectric material A and a layer 13 of a photoelectric material B in Figure 1 may be any one of an n layer, a p layer, an i layer and a layer of other photoelectric material. That is, a layer having a porous structure 15, as long as it is a layer of a photoelectric material, may be any one of an n layer, a p layer, an i layer, and a layer of other photoelectric material.

In Figure 1, although a layer of photoelectric material is schematically illustrated only in two layers, three layers or more may be acceptable. Further, in Figure 1, although an electrode is omitted, in actuality, a photoreceptor surface electrode and a back surface electrode are present up and down. Still further, a pn junction type semiconductor solar cell 11 only has to have a porous structure 15 on a surface thereof, and, here, "a surface" may be a photoreceptor surface or a back surface. However, a porous structure 15 is preferably present on a side of a photoreceptor surface because incident light can be efficiently converted.

In Figure 2, a schematic sectional view of a preferable mode of a pn junction type semiconductor solar cell of an aspect 1 (1) of the present invention is shown. In Figure 2, an upper side is a photoreceptor surface. In Figure 2, a layer 12 of a photoelectric material A is an n layer and a layer 12 of a photoelectric material B is a p layer. In the n layer, a porous structure 15 is present. Further, a silver (Ag) electrode is formed on a photoreceptor surface side, and an aluminum (Al) electrode is formed on a back surface.

A material of an n layer where a porous structure 15 is present is not particularly restricted, as long as it allows to form pores to obtain a porous structure. Preferable examples thereof include crystalline silicon, amorphous silicon, TiO₂ (titania), ZnO (zinc oxide) and so on. Among these, crystalline silicon and amorphous silicon are particularly preferable because it is easy to form pores to form a porous structure.

### <Aspect 1 (2)>

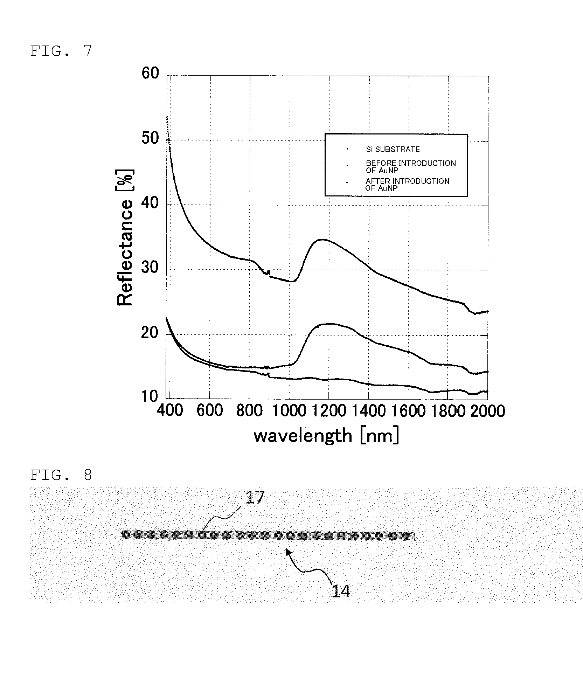

According to a pn junction type semiconductor solar cell of the aspect 1 (2) of the present invention, a porous structure 15 is formed in a light transmission layer 14 (Figure 8) disposed on a surface of a pn junction type semiconductor solar cell. A porous structure 15 is not substantially formed in a photoelectric material itself but is formed in a light transmission layer 14 separately disposed; accordingly, the aspect 1 (2) can be applied to various modes without selecting a mode of a solar cell.

A light transmission layer is disposed on a side of a photoreceptor surface. A material of the light transmission layer is not particularly restricted as long as it allows to transmit solar light and to form pores and a porous structure. Examples thereof include silica, alumina, zirconia and so on.

### <Common to Aspect 1 (1) and (2)>

An average diameter of pores present in the porous structure 15 is not particularly restricted as long as it has a magnitude that allows to support metal nanoparticles having a surface plasmon absorption. However, 0.1 nm to 1000 nm is preferable, 1 nm to 500 nm is more preferable, 2 nm to 200 nm is particularly preferable, and 5 nm to 80 nm is further preferable. When an average diameter of pores is excessively small, in some cases, pores are difficult to form (that is, it is difficult to form a porous structure) or metal nanoparticles may not enter into pores. On the other hand, when an average diameter of pores is excessively large, in some cases, a distance between metal nanoparticles and a pore inner wall may be large or a contact area between metal nanoparticles and a pore inner wall may be small, and an electric field enhancement effect due to surface plasmons becomes difficult to reach.

A thickness of the porous structure 15 is not particularly restricted. However, it is preferable to be 0.02 µm to 1000 µm, more preferable to be 0.1 µm to 1000 µm, still more preferable to be 1 µm to 500 µm, particularly preferable to be 2 µm to 200 µm, and further preferable to be 5 µm to 80 µm. In the case of an excessively thick porous structure, in some cases, it can not be formed, or metal nanoparticles can not enter into a lower portion of pores to be useless. In the case of excessively thin porous structure, in some cases, an amount of metal nanoparticles to be supported becomes slight, and it is difficult to obtain a surface plasmon effect.

Further, the porosity of the porous structure 15 is, from the viewpoint of effectively making use of the surface plasmon effect, preferably 0.005 to 0.8, more preferably 0.1 to 0.6, and particularly preferably 0.2 to 0.4. In the case of excessively large porosity, in some cases, an amount of metal nanoparticles to be supported becomes slight, and the surface plasmon effect is difficult to obtain.

A method for preparing the porous structure is not particularly restricted. A mechanical process such as sintering of particles and the like, a process that uses a photoresist and the like, an etching process that uses a laser, X-ray, electron beam and the like, an anodic oxidation process and the like can be cited. Among these, an anodic oxidation process is preferably used to form a porous structure. In particular, when the anodic oxidation is conducted while dissolving an anodic oxidation film, an anodic oxidation film does not remain on an inner wall of obtained pores; accordingly, when a porous structure is formed in "a photoelectric material itself", "metal nanoparticles" and "a photoelectric material" preferably come into direct contact.

Further, it is preferable also to apply a dry etching process after a porous structure was formed according to the above process. The dry etching process is not particularly restricted as long as it can etch while inhibiting a surface of a porous structure from being oxidized or inhibiting an impurity from attaching. A plasma etching process, an electron beam etching process, an ion beam etching process, an etching process under supply of an etching gas and the like can be cited.

By conducting a dry etching process, layers high in carrier recombination rate such as an amorphous layer, an oxide insulating layer, a defect layer and the like, which are generated during formation of a porous structure by anodic oxidation, can be selectively removed; accordingly, the plasmon effect can be more effectively connected to an improvement in a conversion efficiency of a solar cell. When the above-mentioned layers are selectively etched by applying a dry etching process, a porous material and a dry etching condition are not particularly restricted.

Among dry etching processes, a plasma etching process is particularly preferable from the viewpoint that the effect can be more exerted. When the above-mentioned layers can be selectively etched by applying a plasma etching process, a porous material and a plasma etching condition are not particularly restricted. As the plasma etching process, an argon plasma etching process is more preferable.

A particularly preferable case is a case where a porous structure is formed in "a photoelectric material itself", the material is silicon, and, in an electrolyte solution having the solubility to silicon oxide, an anodic oxidation (anodizing) process is conducted to form a porous structure (pores) in silicon.

The electrolyte solution in this case is not particularly restricted as long as it is a liquid that has the solubility to silicon oxide and can anodize. For example, an aqueous solution of hydrofluoric acid and so on can be cited. In the case of an aqueous solution of hydrofluoric acid, a concentration of hydrofluoric acid is, with respect to an entire electrolyte solution, preferably 30 to 70% by weight and particularly preferably 40 to 60% by weight.

Examples of solvents of an electrolyte solution for anodic oxidation include water; alcohols such as methanol, ethanol, propanol, ethylene glycol and the like; ketones such as acetone, methyl ethyl ketone and the like; mixed solvent of water and these; and so on.

Figure 3 illustrates a schematic diagram when a porous structure is formed on a silicon surface by anodic oxidation. In Figure 3, platinum is used for a negative electrode, and a portion of silicon where the anodic oxidation is not applied is guarded with a fluororesin.

Modes/physical properties of a porous structure such as a thickness, a pore diameter, the density of pores, the stability of a structure and so on of a porous structure formed by anodic oxidation are determined depending on whether an n-type or a p-type, a kind of a dopant, the resistivity, a surface orientation of a surface to be treated, a current density, an electrolysis time, an electrolysis temperature and the like; accordingly, by controlling these, an optimum porous structure is prepared.

In the present invention, "metal nanoparticles" are particles of a metal on a surface of which a plasmon can be localized, and the number average particle size thereof measured by a dynamic light scattering method is in the range of 0.1 to 1000 nm. A preferable range of the number average particle size of the metal nanoparticles is, though depending on the kind of metal that forms metal nanoparticles, 1 to 500 nm, a more preferable range is 2 nm to 200 nm, and a particularly preferable range is 5 nm to 80 nm. When the number average particle size is excessively small, in some cases, it is difficult to prepare metal nanoparticles, a sufficient absorbance enhancement effect can not be obtained because a plasmon absorption peak shifts toward a shorter wavelength side, the reduction of the reflectance becomes insufficient, and so on. On the other hand, when the number average particle size is excessively large, the metal nanoparticles are difficult to enter into pores present in a porous structure, a surface plasmon absorption peak becomes smaller, the absorbance enhancement effect can not be obtained, and so on.

A number average particle size of metal nanoparticles is preferably 0.01 times to 1 times, more preferably 0.1 times to 0.9 times, and particularly preferably 0.2 times to 0.8 times an average diameter of pores in the porous structure. In the range, metal nanoparticles and an inner wall of pores come to the proximity with each other, and a contact area between one metal nanoparticle and a pore inner wall becomes large to be easy to obtain the surface plasmon effect.

A kind of a metal of metal nanoparticles is not particularly restricted. However, silver (Ag), gold (Au), platinum (Pt), copper (Cu), lead (Pb), palladium (Pd) and the like can be cited. Among these, silver (Ag) or gold (Au) is preferable from the viewpoint that an absorption band is in a visible region, oxidation is difficult, metal nanoparticles can be readily prepared, and so on.

Although a method for preparing metal nanoparticles is not particularly restricted, for example, the following methods can be cited. That is, with a phase transfer catalyst, a metal salt dissolved in an aqueous phase is dispersed as metal ion fine particles in an organic phase such as chloroform or the like that is in contact with the aqueous phase, then, after a surface modification compound is added to disturb to grow, the aqueous phase is removed, and, with a reducing agent such as NaBH₄ or the like for example, metal ions are reduced to form metal nanoparticles.

The surface modification compound is important in, other than stopping the growth of the metal nanoparticles as described above, imparting a preferable peripheral dielectric constant. In order to more strongly obtain the electric field enhancement effect, a kind of the surface modification compound is preferably determined also from the dielectric constant thereof. As the surface modification compound, in order to more efficiently obtain the electric field enhancement effect, a surface modification compound that has proper dielectric constant is preferable.

The metal nanoparticle has a surface modification compound on a surface thereof, and the surface modification compound preferably has "a functional group that couples with a metal of metal nanoparticles" Q at one terminal thereof, and has "an organic group that has the affinity to an inner wall of pores present in a porous structure" T at the other terminal. When the surface modification compound has an organic group T, the organic group T is aligned outside of the metal nanoparticles, and, only by dipping in a colloid solution in which metal nanoparticles are dispersed, the metal nanoparticles can be allowed to preferably intrude into pores of a porous structure.

Examples of the functional groups Q include a mercapto group, an amino group, and so on. Regarding the organic group T, in the case where an inner wall of a pore is hydrophobic, the organic group T is preferable to be a hydrophobic group, and in the case where an inner wall of a pore is hydrophilic, the organic group T is preferable to be a hydrophilic group. When an inner wall of a pore is formed of silicon, since a silicon surface is hydrophobic, an organic group T is preferable to be a hydrophobic group. In the case where an inner wall of a pore is hydrophobic, as an organic group T, an alkyl group having 3 to 25 carbon atoms; an aryl group such as a phenyl group or the like that may have a substituent group; and so on are preferable, and an alkyl group having 4 to 18 carbon atoms is particularly preferable. When the number of carbon atoms is excessively abundant, in some cases, the solubility is poor, and, when the number of carbon atoms is excessively slight, in some cases, in the case where the functional group Q is a mercapto group, odor is strong. The surface modification compound may further have one or two or more of dispersion mediaphilic groups such as a carboxyl group, a hydroxyl group and so on.

Metal nanoparticles having the surface modification compound such as described above on a surface can, only by dipping a substance having a porous structure in a colloid solution in which metal nanoparticles are dispersed, enter into pores thereof, thereby the metal nanoparticles can be preferably supported in the pores. By controlling a surface modification compound of metal nanoparticles, in principle, all metal nanoparticles exhibiting a plasmon absorption can be supported in pores of a porous structure; accordingly, all metal nanoparticles that can control a surface modification compound can be used.

Preferable specific examples of the surface modification compounds include 1-octanethiol, 1-decanethiol, 1-dodecanethiol, 1-hexadecanethiol, 11-mercapto-1-undecanol, 3-mercapto propionic acid, 4-mercapto pyridine, 16-mercapto hexadecanoic acid, DNA (deoxyribonucleic acid), PNA (peptide nucleic acid), and so on.

Examples of preferable dispersion media (solvent of colloid solution) of metal nanoparticles include, though depending on a length of an alkyl group in the case where an organic group T is an alkyl group, chloroform, dimethylformamide (DMF), ethanol, propanol, acetone, methyl ethyl ketone (MEK), dichloroethane and so on.

A method for allowing to support metal nanoparticles in pores present in a porous structure is not particularly restricted. However, it is preferable to make metal nanoparticles preferably intrude to the depth of pores. When a preferable surface modification compound is used, only by dipping a substance having a porous structure in a colloid solution in which metal nanoparticles are dispersed, the metal nanoparticles are allowed to intrude into pores and supported. As other supporting methods, also a CVD (chemical vapor deposition) method, a sputtering method, a vacuum deposition method and the like can be cited. A dipping time is not particularly restricted, however, it is preferable to be 2 hr to 4 days and more preferable to be 8 hr to 2 days. When the dipping time is excessively long, in some cases, the dispersibility is deteriorated, and when the dipping time is excessively short, in some cases, metal nanoparticles are difficult to intrude into pores. A temperature is not particularly restricted as long as a dispersion state of the metal nanoparticles can be maintained.

### <Aspect 2>

An aspect 2 of the present invention is a solar cell having a porous structure on a surface thereof, characterized in that a material in which the porous structure is formed is silicon, and in pores present in the porous structure, metal nanoparticles having a surface plasmon absorption are supported. An aspect 2 is completed by finding a method by which a porous structure (pores) is preferably formed on a silicon surface and metal nanoparticles are preferably supported in the pores.

A silicon layer having a porous structure where metal nanoparticles are supported in pores can be disposed on a surface of any of solar cells. Accordingly, the aspect 2 can be applied to all kinds of solar cells without restricting to a pn junction type semiconductor solar cell. The aspect 2 can be preferably applied to silicon solar cells such as a single crystalline silicon solar cell, a polycrystalline silicon solar cell, an amorphous silicon solar cell and so on; a compound semiconductor solar cell; a dye-sensitized solar cell; an organic solar cell; and so on.

Also in the aspect 2, a porous structure is preferably obtained by anodic oxidation in an electrolyte solution having the solubility to a silicon oxide. Preferable method and ranges of the porous structure are the same as those of the aspect 1.

Further, also regarding metal nanoparticles, preferable method and ranges are the same as those of the aspect 1. The metal nanoparticles have a surface modification compound on a surface thereof, and the surface modification compound preferably has, at one terminal, a functional group that couples with a metal of the metal nanoparticles, and, at the other terminal, an organic group having the affinity to silicon.

### <Common between Aspect 1 and Aspect 2>

A method for introducing metal nanoparticles inside of pores of a porous structure to allow to support in pores is not particularly restricted. However, for example, a method where a substance having a porous structure is dipped in a colloid solution in which metal nanoparticles are dispersed can be cited.

According to the present invention, the absorbance of light of a semiconductor thin film and the like can be enhanced according to a local electric field enhancement effect; accordingly, for example, the loss owing to re-coupling (a factor of decrease in photocurrent) caused by thinning of a semiconductor film and so on can be reduced, thereby a high efficiency can be realized.

In the present invention, after disposing a porous structure, further thereon, other layers such as an anti-reflection layer and so on may be disposed.

### Examples

In what follows, the present invention will be more specifically detailed with reference to examples and comparative examples. However, the present invention is not restricted to these examples as long as a gist thereof is not exceeded.

### Example 1

### <Preparation of Metal Nanoparticle>

Firstly, an aqueous phase in which 0.545 g of chlorauric acid (tetrachloroauric acid, HAuClO₄) is dissolved in 30 ml of water and an organic phase in which 0.573 g of tetraoctyl ammonium bromide ((C₈H₁₇) ₄NBr) that is a phase transfer catalyst is dissolved in 20 ml of chloroform were stirred in a vessel at 80 to 90°C for 1 hr to transfer gold ions to the organic phase, thereafter, the aqueous phase was removed.
Next, 35 µL of 1-dodecanethiol (C₁₂H₂₅SH) as a surface modification compound was added to the organic phase and stirred for 15 min.
Thereafter, an aqueous phase where 0.392 g of NaBH₄ that is a reducing agent was dissolved in 24 mL of water was mixed with the organic phase and stirred at room temperature for 12 hr.
Thereby, a liquid in which gold nanoparticles obtained by reducing gold ions in the organic phase and by covering a surface thereof with 1-dodecanethiol (surface-modified) are dispersed in chloroform was prepared. By removing an aqueous phase, a liquid where gold nanoparticles are dispersed in chloroform was obtained (hereinafter, abbreviated as a "gold colloid solution A").

### <Preparation of Porous Structure>

As illustrated in Figure 3, with a silicon substrate at an positive electrode and a platinum counter electrode at a negative electrode, a constant current was flowed by GALVANOSTAT (trade name: TR6143, manufactured by Advantest Corporation) to prepare a porous structure on a surface of a silicon substrate. In order to uniformly flow a current over a surface of a silicon substrate, a silver paste was coated on a back surface and, after pre-baking at 280°C for 3 min, was sintered at 780°C for 30 sec. Further, a circumference of the silicon substrate was protected with a fluororesin tape.

With a mixed solution obtained by mixing an aqueous solution of hydrofluoric acid (46 to 48% by weight) (reagent class, manufactured by Wako Pure Chemical Industries, Ltd.) and ethanol (99.5% by weight) (reagent class, manufactured by Kanto Kagaku) at 1:1 by volume ratio as an electrolyte solution, under the condition shown in Table 1, a porous structure was formed on a surface of the silicon substrate.

**[Table 1]**

| Silicon substrate | Anodic oxidation condition | | Sample No. | Diameter of pore |
|---|---|---|---|---|
| N-type or P-type Resistivity Plane orientation | Current density [mA • cm⁻²] | Electrolysis time [min] | | |
| N-type 2∼50 [Ωcm] (100) | 1 | 10 | 1 | |
| N-type ∼0. 02 [Ωcm] (100) | 300 | 2 | 2 | |
| | | 3 | 3 | Several tens nanometers |
| | | 4 | 4 | |
| | | 4.83(4 min 50 sec) | 5 | |
| | | 5 | 6 | Several tens nanometers |
| | | 7 | 7 | Several tens nanometers |
| | | 10 | 8 | |
| | 200 | 8 | 9 | Several tens nanometers |
| | | 10 | 10 | Several tens nanometers |
| | 100 | 10 | 11 | 10∼20 n m |
| P-type 1∼3 [Ωcm] (100) | 300 | 2 | 12 | |
| | | 3 | 13 | |
| | 50 | 10 | 14 | |
| | | 2 | 15 | Not detected |
| P-type 7∼12 [Ωcm] (100) | 300 | 3 | 16 | Several micrometers |

### <Observation and Evaluation of Porous Structure>

A surface of the silicon substrate prepared above was observed with a scanning electron microscope (SEM) (trade name: JSM-6460, manufactured by JEOL), and an atomic force microscope (AFM) (trade name: VEECO MULTIMODE N3-IHA, manufactured by SPM System). Regarding the SEM observation, two kinds of observations were performed, that is, a surface image seen from above a surface and an image of a cross section observed horizontally were observed. Regarding the AFM observation, the observation was conducted according to a tapping mode that uses a silicon cantilever having the spring constant of 20-80N m-1.

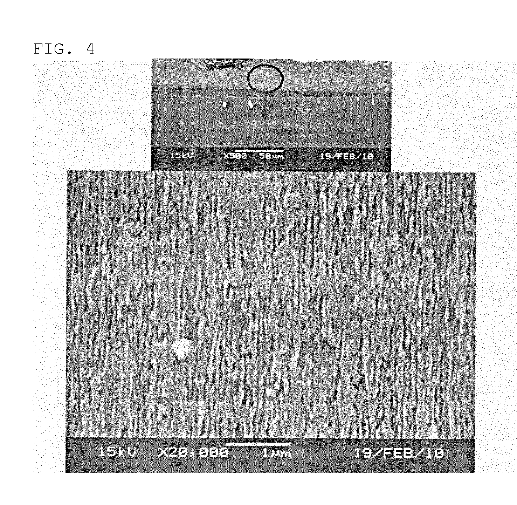

In sample 3, pores having a diameter of several tens nanometers were confirmed. In Figure 4, a SEM photograph of a cross section is shown. It was confirmed that pores extend in a vertical direction. Pores like this continued over about 40 µm of a depth of the silicon substrate. In the present specification, "several" of "several tens nanometers", "several micrometers" and so on indicates about 2 to about 6.

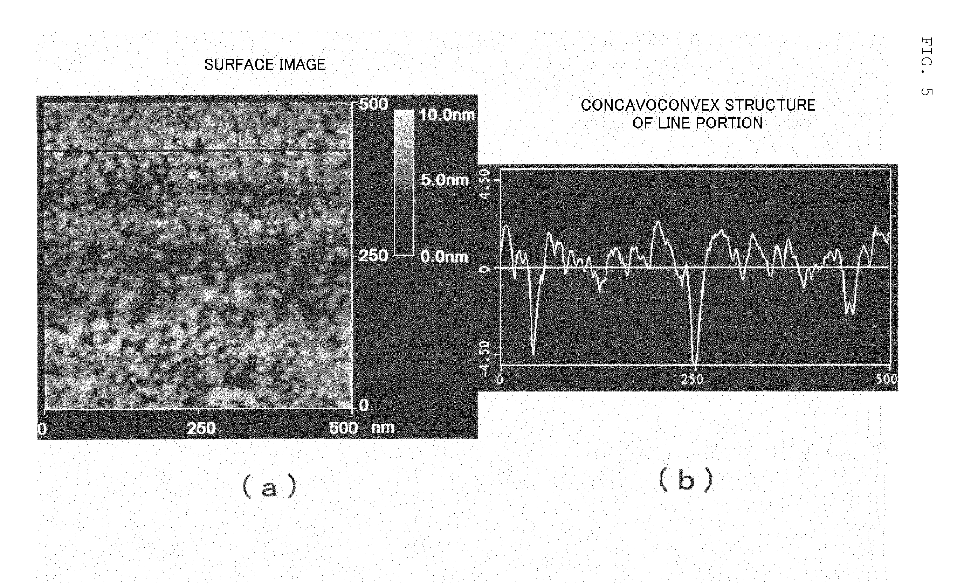

Regarding the sample 3, in order to observe in more detail, a surface thereof was observed with AFM. In Figure 5 (a), an AFM image of a surface was shown, and in Figure 5(b), a concavoconvex structure along a horizontal portion of Figure 5 (a) was illustrated. From Figure 5 (a), pores of several tens nanometers could be observed, and from Figure 5(b), it was observed that a diameter of one of these is 27.3 nm.

It was confirmed from Figures 4 and 5 that, in sample 3, pores the same as 10 to 30 nm of a preferable average particle diameter of the metal nanoparticles or larger than that are present on a surface, and the pores extend vertically straight as shown in Figure 4. Further, the sample 3 is stable also as a porous structure; accordingly, it is considered suitable for introducing metal nanoparticles.

In sample 8, a first layer and a second layer were different in mode. On a surface of the second layer, pores of about 10 to 100 nm were clearly confirmed. On a surface of the first layer that is an original surface, pores of several tens nanometers were confirmed; however, it was not so clear as that of the second layer. Regarding a magnitude of the pores, it was considered suitable for introducing metal nanoparticles.

In sample 11, a pore could not be confirmed on a surface. However, when a surface thereof was scratched with a pincette and the inside of the scratch was observed, pores could be confirmed. Although pores that could be confirmed had a diameter of about 10 to 20 nm that is slightly small, it was considered possible to introduce metal nanoparticles.

Although a pore could not be confirmed on a surface of sample 15, pores having a diameter of several micrometers could be confirmed on a surface of sample 16. Not only in an n-type but also in a p-type, a porous structure could be formed.

Thus, depending on a kind of a dopant in silicon, the optimum condition for preparing pores (porous structure) is different. However, it was found that in a silicon substrate, in any of the n-type and p-type, a porous structure can be prepared.

### <Supporting Metal Nanoparticles in Pores of Porous Structure>

With the sample 3 prepared above, metal nanoparticles were supported in pores of a porous structure formed on a surface thereof. The sample 3 prepared above was dipped in a gold colloid solution A for 66 hr. After pulling up, a surface was lightly cleaned with a solvent.

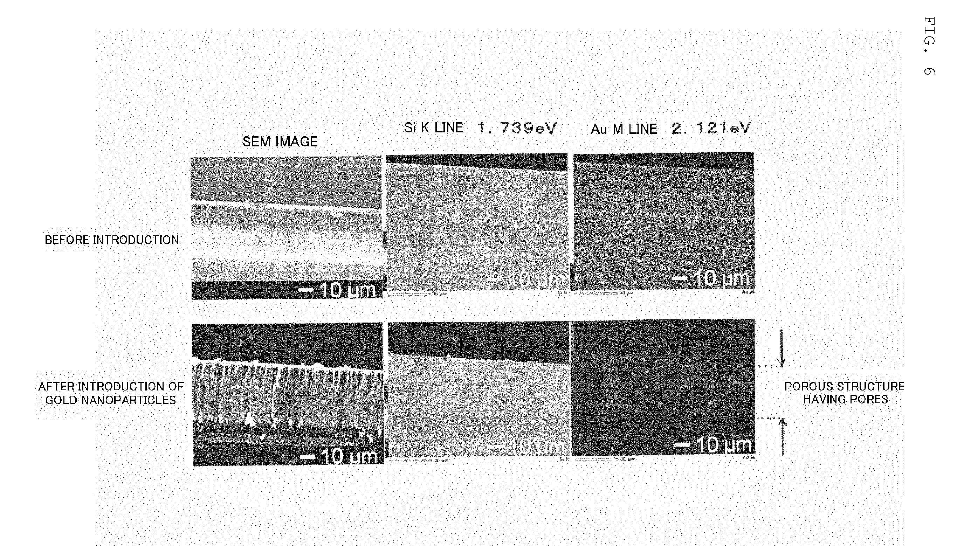

A cross section of the sample 3 after introduction of gold nanoparticles was observed by energy dispersive X-ray analyzer (EDS). As the EDS, JED-2300 (trade name, manufactured by JEOL) attached to SEM was used. In Figure 6, SEM images and EDS images of cross-sections of the sample 3 before and after introduction of gold nanoparticles are illustrated. Each of the diagrams was obtained by photographing or scanning the same place.

In an actual image measured by detecting Si K line (1.739 keV) in Figure 6, both a portion of a porous structure before introduction and a portion therebelow were set to be colored in orange when a signal is strong. Since both were colored in orange, it goes without saying that a signal of Si is strong. After introduction, a portion of a porous structure was colored in green that is a color when the signal became weak. On the other hand, a portion therebelow was found to remain in orange as it is to be strong in signal as it is. From this, it was confirmed that after the sample 3 was dipped in a gold colloid solution A for 66 hr, a Si intensity of a portion of a porous structure became relatively weak, and it was indicated that owing to an intrusion of Au, the Si intensity became relatively weak.

On the other hand, in an actual image measured by detecting Au M line (2.121 keV) in Figure 6, both a portion of a porous structure before introduction and a portion therebelow were set to be colored in gray when a signal is not detected. Since both were colored in gray, it goes without saying that a signal of Au is not present. After introduction, a portion of a porous structure was colored in red-brown that is a color when the signal became strong. On the other hand, a portion therebelow was found to remain in gray as it is to be incapable of detecting a signal. From this, it was confirmed that after the sample 3 was dipped in a gold colloid solution A for 66 hr, a Au intensity only of a portion of a porous structure became strong (that is, presence of Au). Further, after the sample 3 was dipped in a gold colloid solution A for 66 hr, a portion of the porous structure was colored in red-brown the same in a depth direction; accordingly, it was confirmed that substantially uniformly in a depth direction of the porous structure, gold nanoparticles intruded. That is, it was confirmed that substantially uniformly to the deepest portion of pores, gold nanoparticles intruded.

As a result of quantitative analysis, from a portion of a porous structure after the sample 3 was dipped in a gold colloid solution A for 66 hr, 2.00% by atom of gold was detected, that is, a clear increase could be confirmed.

### <Affinity of Silicon Surface with Metal Nanoparticle>

When a silicon substrate is left in air for a long time, an oxide film is formed on a surface thereof. This oxide film can be removed by dipping in an aqueous solution of hydrofluoric acid. A silicon substrate after removal is terminated with hydrogen and a silicon substrate in this state is hydrophobic. It is considered that the inside of the pore is similarly hydrophobic. On the other hand, gold nanoparticles are modified with 1-dodecanethiol and hydrocarbon groups are outwardly directed. This is found also from a fact that the gold nanoparticles are well dispersed in chloroform that is a non-polar solvent. From what was described above, it is considered that an inner wall of pores of silicon and the gold nanoparticles are excellent in the compatibility; accordingly, the gold nanoparticles can uniformly enter to the deepest portion of pores.

### <Deliberation as Solar Cell>

A reflection spectrum was measured with a UV/VIS/NIR spectrophotometer (trade name: V-570, manufactured by JASCO Corporation). Results are shown in Figure 7. From above, "silicon substrate", "sample obtained by forming a porous structure on silicon substrate surface by anodic oxidation" (denoted in Figure 7 as "before AuNP introduction"), and sample obtained by supporting gold nanoparticles in pores of a porous structure (denoted in Figure 7 as "after AuNP introduction") are sequentially shown.

The reflectance of the "after AuNP introduction" was remarkably reduced in comparison with that of the "before AuNP introduction". From this, it could be confirmed that owing to the presence of gold nanoparticles, the reflectance was reduced. In the "after AuNP introduction", in comparison with an initial "silicon substrate", a larger reduction in the reflectance could be confirmed. That is, both of the formation of a porous structure and the support of gold nanoparticles in pores could reduce the reflectance.

From the viewpoint of the antireflection effect, silicon that supports the gold nanoparticles contributes to enhance an efficiency of a solar cell. That is, when silicon that supports gold nanoparticles is used, a pn junction type semiconductor solar cell excellent in the energy conversion efficiency can be obtained.

What was described above related to the case where a porous structure was formed in a photoelectric material itself (aspect 1 (1)). Even in the case where a porous structure is formed in a light transmission layer disposed on a surface of a pn junction type semiconductor solar cell (aspect 1 (2)), the similar effect can be exerted.

Also in the case when silicon that supports metal nanoparticles in pores thereof is applied to not only a pn junction type semiconductor solar cell but also other solar cells (aspect 2), the effect the same as that described above can be exerted. Accordingly, a solar cell having a porous structure on a surface thereof, characterized in that a material in which the porous structure is formed is silicon, and, in pores present in the porous structure, metal nanoparticles having a surface plasmon absorption are supported, is excellent in the energy conversion efficiency.

### Example 2

### <Preparation of Metal Nanoparticles>

Firstly, an aqueous phase in which 0.161 g of chlorauric acid (tetrachloroauric acid, HAuClO₄) is dissolved in 30 ml of water and an organic phase in which 0.573 g of tetraoctyl ammonium bromide ((C₈H₁₇) ₄NBr) that is a phase transfer catalyst is dissolved in 40 ml of dichloromethane were stirred in a vessel at room temperature (25°C) for 1 hr to transfer gold ions to the organic phase, thereafter, the aqueous phase was removed.

Next, 0.167 g of 11-mercapto-1-undecanol (HOC₁₁H₂₂SH) as a surface modification compound was added to the organic phase and stirred for 15 min. Thereafter, an aqueous phase where 0.392 g of NaBH₄ that is a reducing agent was dissolved in 24 mL of water was mixed with the organic phase and stirred at room temperature for 3 hr.

Next, therein, 12 ml of 3% hydrochloric acid was added and stirred for 1 hr. The solution was suction filtered, followed by cleaning with a large amount of water. Further, after cleaning twice with 2 ml of dichloromethane and sufficiently drying, the filtrate was dissolved in ethanol, thereby a liquid where gold nanoparticles are dispersed in ethanol (hereinafter, abbreviated as "gold colloid solution B") was obtained.

### <Preparation of Porous Structure>

Except that in sample 12 of example 1, an electrolysis time was set to 1 sec, according to example 1, a porous structure was prepared (referred to as sample 17). That is, a silicon substrate that is p-type and has the resistivity of 1 to 3 Ωcm, a plane orientation (100), and a pn-junction formed by thermal diffusion of phosphorus (P) was used.

### <Supporting Metal Nanoparticles in Pores of Porous Structure>

With the sample 17 prepared above, metal nanoparticles were supported in pores of a porous structure formed on a surface thereof. That is, the sample 17 prepared above was dipped in the gold colloid solution B prepared above for 48 hr. After pulling up, a surface was lightly cleaned with a solvent.

### <Deliberation as Solar Cell>

A reflection spectrum was measured with a UV/VIS/NIR spectrophotometer (trade name: V-570, manufactured by JASCO Corporation). Results are shown in Figure 9. From above, "sample obtained by forming a porous structure on a silicon substrate surface by anodic oxidation" (denoted in Figure 9 as "before introduction of Au"), and "sample obtained by supporting gold nanoparticles in pores of a formed porous structure" (denoted in Figure 9 as "after introduction of Au ") are sequentially shown.

The reflectance of the "after introduction of Au " was remarkably reduced in comparison with that of the "before introduction of Au ". From this, it could be confirmed that owing to the presence of gold nanoparticles, the reflectance was reduced.

### Example 3

### <Preparation of Metal Nanoparticles>

The gold colloid solution A of example 1 was used.

### <Preparation of Porous Structure>

Except that in sample 9 prepared in example 1, an electrolysis time was set to 3 min, in a manner similar to that of sample 9, a porous structure was prepared. This sample is called as "sample 9'".

Subsequently, with the sample 9', under the following condition, in an Ar plasma, a dry etching process was conducted. That is, the sample 9' was dry etched with a plasma etching device (trade name: SEDE SOFT ETCHING DEVICE, manufactured by MEIWA FOCIS Co., Ltd.) for 30 min under 10 Pa while introducing argon gas at room temperature (25°C).
The obtained sample is referred to as "sample 9''".

### <Observation and Evaluation of Porous Structure>

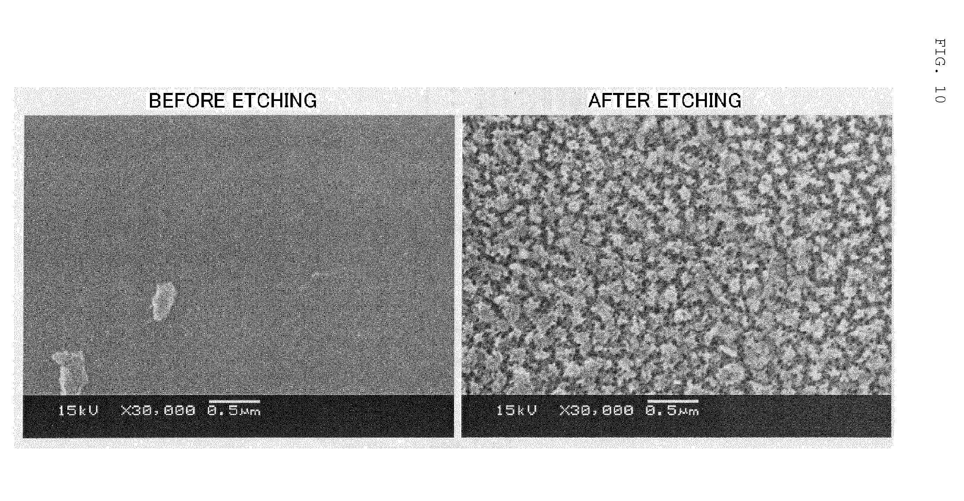

Scanning electron microscope (SEM) photographs of surfaces of the porous structures (pores) before and after dry etching are illustrated in Figure 10. Also in a sample before dry etching (sample 9'), as described above, a porous structure where a pore diameter is several tens nanometers was formed. However, the porous structure could not be confirmed by SEM observation under the corresponding magnitude. However, after dry etching (sample 9"), a porous structure could be confirmed by SEM observation under the corresponding magnitude.

### <Supporting Metal Nanoparticles in Pores of Porous Structure>

With the sample 9" prepared above, metal nanoparticles were supported in pores of a porous structure formed on a surface thereof. That is, the sample 9" prepared above was dipped in the gold colloid solution A prepared above for 18 hr. After pulling up, a surface was lightly cleaned with a solvent.

### <Deliberation as Solar Cell>

A reflection spectrum was measured with a UV/VIS/NIR spectrophotometer (trade name: V-570, manufactured by JASCO Corporation). Results are shown in Figure 11. Spectra shown in Figure 11 are as illustrated below.
1: Silicon substrate obtained by forming a porous structure on a surface thereof by anodic oxidation (sample 9') (without etching and before dipping),
2: silicon substrate obtained by supporting gold nanoparticles in pores of the porous structure of the 1 (without etching and after dipping),
3: silicon substrate obtained by forming a porous structure on a surface thereof by anodic oxidation and dry etching (sample 9") (with etching and before dipping), and
4: silicon substrate obtained by supporting gold nanoparticles in pores of the porous structure of the 3 (with etching and after dipping).

After gold nanoparticles were supported, the reflectance was remarkably reduced in comparison with that of a sample before supporting. Further, by applying the dry etching, the reflectance was remarkably reduced.

### Example 4

### <Preparation of Metal Nanoparticles>

Firstly, an aqueous phase in which 0.076 g of silver nitrate (AgNO₃) is dissolved in 30 ml of water and an organic phase in which 2.231 g of tetraoctyl ammonium bromide ((C₈H₁₇) ₄NBr) that is a phase transfer catalyst is dissolved in 40 ml of dichloromethane were stirred in a vessel at room temperature (25°C) for 1 hr to transfer silver ions to the organic phase, thereafter, the aqueous phase was removed.

Next, 0.162 g of 11-mercapto-1-undecanol (HOC₁₁H₂₂SH) as a surface modification compound was added to the organic phase and stirred for 15 min. Thereafter, an aqueous phase where 0.392 g of NaBH₄ that is a reducing agent is dissolved in 24 mL of water was mixed with the organic phase and stirred at room temperature for 3 hr.

Next, 12 ml of 3% hydrochloric acid was added therein and stirred for 1 hr. The solution was suction filtered and cleaned with a large amount of water. Further, after cleaning twice with 2 ml of dichloromethane and sufficiently drying, the filtrate was dissolved in ethanol, thereby a liquid where silver nanoparticles are dispersed in ethanol (hereinafter, abbreviated as "silver colloid solution") was obtained.

### <Preparation of Porous Structure>

The sample 3' prepared in example 3 was used. That is, the sample 3' obtained by dry etching the sample 3 prepared in example 1 in an Ar plasma was used.

### <Supporting Metal Nanoparticles in Pores of Porous Structure>

With the sample 3' prepared above, metal nanoparticles were supported in pores of a porous structure formed on a surface thereof. That is, the sample 3' prepared above was dipped in the silver colloid solution for 72 hr (for 3 days). After pulling up, a surface was lightly cleaned with a solvent.

A cross-section of the sample 3' after introduction of silver nanoparticles was observed by SEM and energy dispersive X-ray analyzer (EDS). As the EDS, JED-2300 (trade name, manufactured by JEOL) attached to SEM was used.

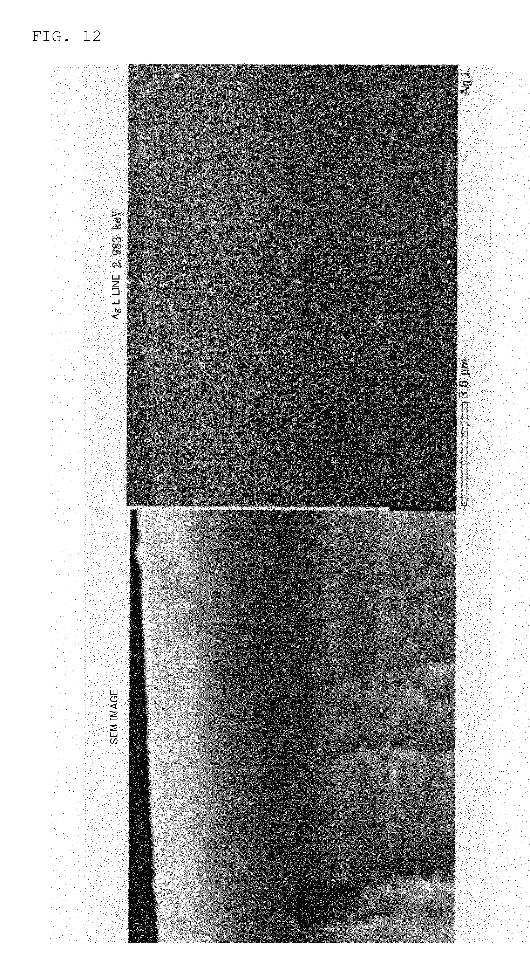

In Figure 12, a SEM (left in Figure 12) and an EDS image (right in Figure 12) of a cross-section of the sample 3' after introduction of silver nanoparticles are shown. Each of the images was taken (scanned) on the same position. An actual EDS image was imaged (scanned) so that a portion where an intensity of a Ag L line (2.983 keV) is strong may be turned green.

In an actual image measured by detecting a Ag L line (2.983 keV) of Figure 12, after introduction, a portion of a porous structure turned green that is a color when a signal is strong. On the other hand, a portion therebelow remained grey as it is, that is, a signal could not be detected.
After the sample 3' was dipped in the silver colloid solution for 72 hr, a silver intensity of only a portion of the porous structure became strong; accordingly, it was confirmed that silver nanoparticles are introduced in the porous structure (pores).

According to an EDS image of Figure 12 right, after the sample 3' was dipped in the silver colloid solution for 72 hr, an upper portion of the porous structure turned green in a depth direction; accordingly, it was confirmed that silver nanoparticles intruded in a depth direction of the porous structure.

### <Deliberation as Solar Cell>

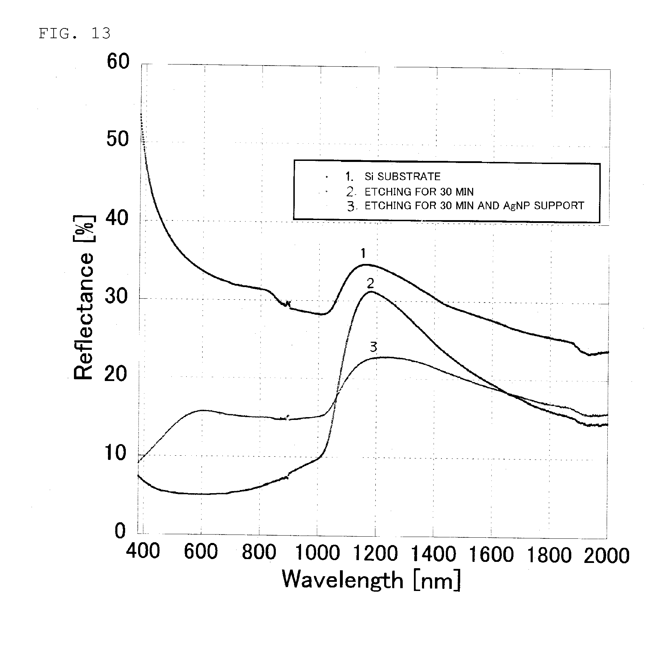

A reflection spectrum was measured with a UV/VIS/NIR spectrophotometer (trade name: V-570, manufactured by JASCO Corporation). Results are shown in Figure 13.

Spectra in Figure 13 are as illustrated below.
1: Silicon substrate,
2: silicon substrate obtained by forming a porous structure on a surface thereof, followed etching (sample 3', denoted as "2. Etching for 30 min" in Figure 13), and
3: silicon substrate obtained by supporting silver nanoparticles in pores of a porous structure (denoted as "3. Etching 30 min and AgNP support" in Figure 13).

From Figure 13, it was found that the reflectance was reduced by dry etching. Further, it could be confirmed that owing to the presence of silver nanoparticles, the reflectance was reduced. In particular, the reflectance could be remarkably reduced on a long wavelength side. In comparison with the initial "Si substrate", by combining both of the dry etching and the support of silver nanoparticles in a porous structure, the reflectance could be largely reduced.

From the viewpoint of the antireflection effect, the silicon that supports silver nanoparticles largely contributes to improve efficiency of solar cell. That is, when silicon that supports silver nanoparticles is used, a pn junction type semiconductor solar cell excellent in the energy conversion efficiency can be obtained.

In what was described above, a case where a porous structure is formed in a photoelectric material itself (aspect 1 (1)) was described. However, even when a porous structure is formed in a light transmission layer disposed on a surface of a pn junction type semiconductor solar cell (aspect 1 (2)), the same effect can be exerted.

Also in the case when silicon that supports silver nanoparticles in pores thereof is applied to not only a pn junction type semiconductor solar cell but also other solar cells (aspect 2), the effect the same as that described above can be exerted. Accordingly, a solar cell having a porous structure on a surface thereof, characterized in that a material in which the porous structure is formed is silicon, and, in pores present in the porous structure, silver nanoparticles having a surface plasmon absorption are supported, is excellent in the energy conversion efficiency.

### Example 5

### <Preparation of Metal Nanoparticles>

The gold colloid solution A of example 1 was used.

### <Preparation of Porous Structure>

Except that in example 1, a current density of the sample 13 was set to 10 mA cm⁻² for 3 min, in a manner similar to that of example 1, a porous structure was prepared (referred to as sample 18).

According to the method described in example 2, dry etching was performed in an Ar plasma. The obtained sample is referred to as "sample 18'".

### <Supporting Metal Nanoparticles in Pores of Porous Structure>

With the sample 18' prepared above, metal nanoparticles were supported in pores of a porous structure formed on a surface thereof according to the method described in example 1. In the gold colloid solution A of example 1, the sample 18' prepared above was dipped for 72 hr (3 days). After pulling up, a surface was lightly cleaned with a solvent.

### <Deliberation as Solar Cell>

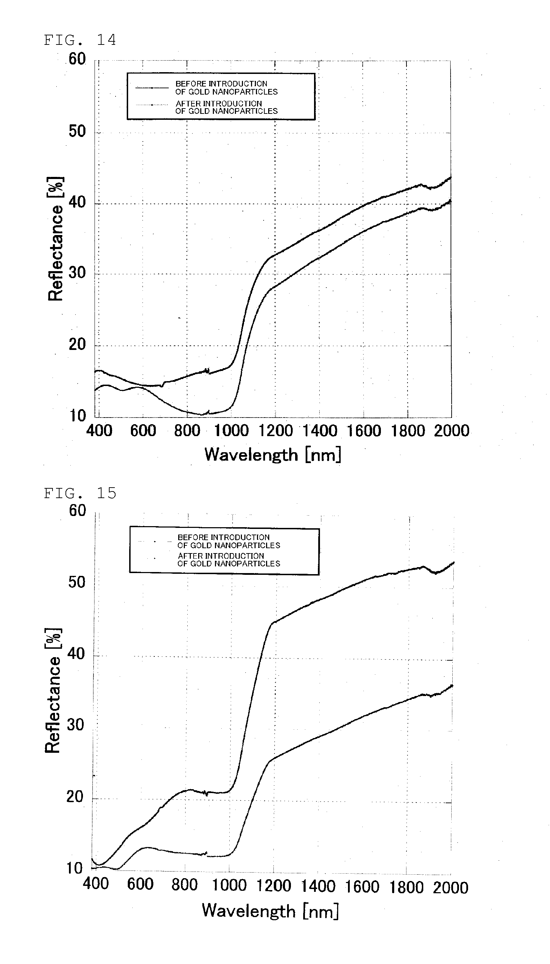

A reflection spectrum was measured with a UV/VIS/NIR spectrophotometer (trade name: V-570, manufactured by JASCO Corporation). Results are shown in Figure 14. In Figure 14, spectra are as shown below from top down.
"Silicon substrate obtained by forming a porous structure on a surface thereof" (denoted by "before introduction of gold nanoparticles" in Figure 14), and
"silicon substrate obtained by supporting gold nanoparticles in pores of a porous structure" (denoted by "after introduction of gold nanoparticles" in Figure 14).

The silicon substrate "after introduction of gold nanoparticles" exhibited a remarkable decrease in the reflectance compared with the silicon substrate "before introduction of gold nanoparticles". Thereby, it was confirmed that owing to the presence of gold nanoparticles, the reflectance is reduced.

### Example 6

Except that in example 5, an electrolysis time of the sample 18 was set to 10 min, according to example 4, a porous structure was prepared (referred to as sample 19').

### <Supporting Metal Nanoparticles in Pores of Porous Structure>

With sample 19' prepared above, metal nanoparticles were supported in pores of a porous structure formed on a surface thereof according to a method described in example 1. That is, the sample 19' prepared above was dipped in the gold colloid solution A for 72 hr (for 3 days). After pulling up, a surface was lightly cleaned with a solvent.

### <Deliberation as Solar Cell>

A reflection spectrum was measured with a UV/VIS/NIR spectrophotometer (trade name: V-570, manufactured by JASCO Corporation). Results are shown in Figure 15. In Figure 15, spectra are as shown below from top down.
"Silicon substrate obtained by forming a porous structure on a surface thereof" (denoted as "before introduction of gold nanoparticles" in Figure 15), and
"silicon substrate obtained by supporting gold nanoparticles in pores of a porous structure" (denoted as "after introduction of gold nanoparticles" in Figure 15).

The "after introduction of gold nanoparticles" had the reflectance remarkably reduced compared with that of the "before introduction of gold nanoparticles". From this, it could be confirmed that owing to the presence of gold nanoparticles, the reflectance is reduced.
Further, in comparison with example 5 (electrolysis time: 3 min), in example 6 where the electrolysis time is longer (electrolysis time: 10 min), the reflectance on a longer wavelength side was remarkably reduced. This is considered because the longer the electrolysis time is, the thicker a thickness of a layer having the porous structure is.

### Example 7

### <Preparation of Porous Structure>

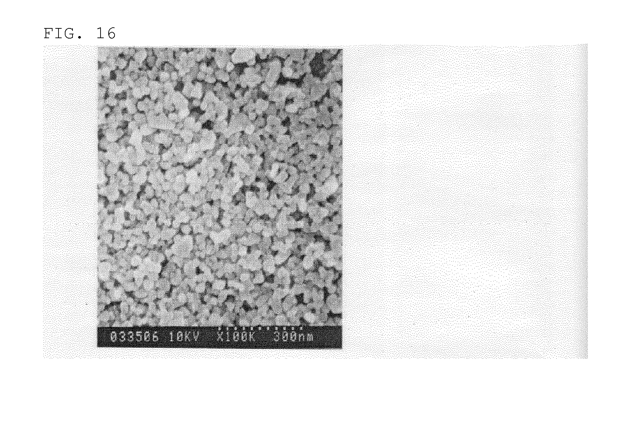

Firstly, TiO₂ powder (trade name: P-25, manufactured by Nippon Aerosil Co., Ltd.) and a solution of ethanol, acetylacetone, Triton X-100 diluted to 10 times and polyethylene glycol were mixed by a planetary ball mill to prepare a paste for forming a film having a TiO₂ porous structure. Then, the prepared paste was coated by doctor blade on a glass with a transparent electrode film, and sintered at 450°C to prepare a TiO₂ porous structure (Figure 16).

When, in a manner similar to that of example 1, metal nanoparticles (gold nanoparticles) were supported and studied as a solar cell, an increase in the absorbance of light was found after introduction of metal nanoparticles (not shown in the drawing).

### Industrial Applicability

A solar cell such as a pn junction type semiconductor solar cell or the like of the present invention has metal nanoparticles at high density on a surface thereof; accordingly, when a localized electric field enhancement effect due to a surface plasmon absorption that the metal nanoparticles like this have is utilized, owing to an increase in the absorbance of light on a solar cell surface, a decrease in the reflectance, and so on, a solar cell having high energy conversion efficiency can be provided; accordingly, a solar cell can be used in a wide industrial field.

The present patent application is based on Japanese Patent Application No. 2010-063647 filed on March 19, 2010, and an entire content thereof is incorporated herein by reference.

## Claims

1. A pn junction type semiconductor solar cell having a porous structure on a surface thereof, **characterized by** supporting metal nanoparticles having a surface plasmon absorption in pores present in the porous structure.

2. The pn junction type semiconductor solar cell according to claim 1, wherein the porous structure is formed in a photoelectric material itself in a pn junction type semiconductor solar cell.

3. The pn junction type semiconductor solar cell according to claim 1, wherein the porous structure is formed in a light transmission layer disposed on a surface of a pn junction type semiconductor solar cell.

4. The pn junction type semiconductor solar cell according to claim 2, wherein a photoelectric material in which the porous structure is formed is crystalline silicon or amorphous silicon.

5. The pn junction type semiconductor solar cell according to claim 4, wherein the porous structure is formed by anodic oxidation of crystalline silicon or amorphous silicon in an electrolyte solution having the solubility to a silicon oxide.

6. The pn junction type semiconductor solar cell according to claim 5, wherein the porous structure is obtained by, after anodic oxidation in an electrolyte solution, further dry etching.

7. The pn junction type semiconductor solar cell according to any one of claims 1 to 6, wherein the metal nanoparticles have a surface modification compound on a surface thereof, the surface modification compound has at one terminal thereof a functional group that couples with a metal of the metal nanoparticles and at the other terminal an organic group having the affinity to an inner wall of pores present in the porous structure.

8. The pn junction type semiconductor solar cell according to any one of claims 1 to 7, wherein a metal of the metal nanoparticles is gold or silver.

9. A solar cell having a porous structure on a surface thereof, **characterized in that** a material in which the porous structure is formed is silicon, and in pores present in the porous structure, metal nanoparticles having a surface plasmon absorption are supported.

10. The solar cell according to claim 9, wherein the porous structure is obtained by anodic oxidation in an electrolyte solution having the solubility to a silicon oxide.

11. The solar cell according to claim 10, wherein the porous structure is obtained by, after anodic oxidation in an electrolyte solution, further dry etching.

12. The solar cell according to any one of claims 9 to 11, wherein the metal nanoparticles have a surface modification compound on a surface thereof, the surface modification compound has at one terminal thereof a functional group that couples with a metal of the metal nanoparticles and at the other terminal an organic group having the affinity to silicon.
